(19) **Europäisches Patentamt European Patent Office Office européen des brevets**

(11) **EP 4 513 211 A1**

(12) **EUROPEAN PATENT APPLICATION**
published in accordance with Art. 153(4) EPC

(43) Date of publication:
26.02.2025 Bulletin 2025/09

(21) Application number: 23921488.5

(22) Date of filing: 30.11.2023

(51) International Patent Classification (IPC):
$G01R\ 31/367^{(2019.01)}$  $G01R\ 31/392^{(2019.01)}$
$G01R\ 31/374^{(2019.01)}$  $G07C\ 9/00^{(2020.01)}$

(52) Cooperative Patent Classification (CPC):
G01R 31/367; G01R 31/374; G01R 31/392;
G07C 9/00

(86) International application number:
PCT/KR2023/019589

(87) International publication number:
WO 2024/167115 (15.08.2024 Gazette 2024/33)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 06.02.2023 KR 20230015396

(71) Applicant: **LG Energy Solution, Ltd.**
**Seoul 07335 (KR)**

(72) Inventors:
• **CHO, Inhwan**
**Daejeon 3412 (KR)**

• **KANG, Juyoung**
**Daejeon 3412 (KR)**
• **PARK, Heungil**
**Daejeon 3412 (KR)**
• **SEO, Jungoh**
**Daejeon 3412 (KR)**
• **LEE, Dajin**
**Daejeon 3412 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSTIC DEVICE AND METHOD**

(57) A battery diagnosis apparatus located within a battery system may include at least one processor; and a memory configured to store at least one instruction executed by the at least one processor.

Here, the at least one instruction may include an instruction to diagnose whether a battery is abnormal based on at least one battery state value during a process of charging and discharging the battery; an instruction to generate a first diagnosis result when an abnormality occurs in the battery; an instruction to verify validity of the first diagnosis result based on whether a door provided on a container accommodating the battery is opened or closed; and an instruction to output the first diagnosis result as a final diagnosis result in the instance that the first diagnosis result is determined to be valid.

**EP 4 513 211 A1**

[Figure 3]

**EP 4 513 211 A1**

100

10

BAT #1 | BAT #2 | ... | BAT #N

200

battery diagnosis apparatus

300

operator terminal

**Description**

[Technical Field]

This application claims priority to and the benefit of Korean Patent Application No.10-2023-0015396 filed in the Korean Intellectual Property Office on February 6, 2023 the entire contents of which are incorporated herein by reference.

The present invention relates to a battery diagnosis apparatus and method, and more particularly, to a battery diagnosis apparatus and method for preventing misdiagnosis due to opening and closing of a container including a battery.

[Background Art]

Secondary batteries, capable of recharging and reuse may be used as an energy source for small devices such as mobile phones, tablet PCs, and vacuum cleaners and may also be used as energy source for a medium-to-large devices, such as automobiles and an energy storage system (ESS) for smart grids.

Secondary batteries may be used in the form of an assembly such as a battery module in which a plurality of battery cells is connected in series or parallel, or a battery pack in which a plurality of battery modules is connected in series or parallel, depending on the requirements of the system. In the case of medium-to-large devices such as electric vehicles, a high-capacity battery system with multiple battery packs connected in parallel may be applied to meet the required capacity of a corresponding device.

Battery cells are manufactured through an assembly process and an activation process. Since battery cells are assembled in a discharged state, an activation process must be performed after the battery cell assembly process to activate positive electrode active material and create surface film (SEI: Solid Electrolyte Interface) on the negative electrode, so as to function as a battery. This activation process is called a formation process.

The formation process may be performed in a manner in which a charging and discharging device repeatedly charges and discharges battery cells according to preset voltage and current conditions using an electrode probe. In addition, electrical characteristics may be measured during the charging and discharging process of the battery cells after the battery cells are mounted on the charging and discharging device used in the formation process, in order to test the performance of the battery cells.

During the process of charging and discharging test of the battery, monitoring one or more state values of the battery is performed to diagnose abnormalities such as whether ignition has occurred. Here, in the instance that a door of a container in which the battery is accommodated opened, the state value of the battery may be distorted due to temperature change or physical shock, which may result in misdiagnosis.

Thus, as a technical solution that can solve these problems of the prior art, an appropriate battery diagnosis technology is needed to prevent misdiagnosis due to opening and closing of a container in which the battery is accommodated.

[Detailed Description of the Invention]

[Technical Problem]

To obviate one or more problems of the related art, embodiments of the present disclosure provide a battery diagnosis apparatus that can prevent misdiagnosis due to opening and closing of a container in which a battery is accommodated.

To obviate one or more problems of the related art, embodiments of the present disclosure also provide a battery diagnosing method performed by the battery diagnosis apparatus.

To obviate one or more problems of the related art, embodiments of the present disclosure also provide a battery test system including the battery diagnosis apparatus.

[Technical Solution]

In order to achieve the objective of the present disclosure, a battery diagnosis apparatus located within a battery system may include at least one processor; and a memory configured to store at least one instruction executed by the at least one processor. Here, the at least one instruction may include an instruction to diagnose whether a battery is abnormal based on at least one battery state value during a process of charging and discharging the battery; an instruction to generate a first diagnosis result when an abnormality occurs in the battery; an instruction to verify validity of the first diagnosis result based on whether a door provided on a container accommodating the battery is opened or closed; and an instruction to output the first diagnosis result as a final diagnosis result in the instance that the first diagnosis result is determined to be valid.

The instruction to verify validity of the first diagnosis result may include an instruction to check door status information at the time the at least one battery state value is collected; an instruction to determine the first diagnosis result as valid when it is confirmed that the door is in a closed state; and an instruction to determine that the first diagnosis result is invalid when it is confirmed that the door is in an open state.

The at least one instruction may further include an instruction to invalidate the first diagnosis result in the instance that the first diagnosis result is determined to be invalid.

The instruction to invalidate the first diagnosis result may include an instruction to correct the battery state value using the information on door status; and an instruction to re-diagnose whether the battery is abnormal based on the corrected battery state value.

Here, the instruction to re-diagnose whether the battery is abnormal may include an instruction to generate a second diagnosis result in the instance that it is determined that an abnormality has occurred in the battery as a result of re-diagnosis; and an instruction to output the second diagnosis result as a final diagnosis result.

The instruction to correct the battery state value may include an instruction to determine a duration for which the door is open; and an instruction to correct a battery state value associated with internal temperature of the container based on the duration for which the door is open.

The instruction to correct the battery state value may include an instruction to determine whether correction of the battery state value is possible based on an amount of change in the battery state value.

Here, the instruction to determine whether the correction of the battery state value is possible may include an instruction to determine that the correction of the battery state value is impossible in the instance that the amount of change in the battery state value exceeds a predetermined threshold.

According to another embodiment of the present disclosure, a battery diagnosing method, performed by a battery diagnosis apparatus located within a battery system, may include diagnosing whether a battery is abnormal based on at least one battery state value during a process of charging and discharging the battery; generating a first diagnosis result in the instance that an abnormality occurs in the battery; verifying validity of the first diagnosis result based on whether a door provided on a container accommodating the battery is opened or closed; and outputting the first diagnosis result as a final diagnosis result in the instance that the first diagnosis result is determined to be valid.

The verifying validity of the first diagnosis result may include checking information on door status at the time the at least one battery state value is collected; determining the first diagnosis result as valid in the instance that it is confirmed that the door is in a closed state; and determining that the first diagnosis result is invalid in the instance that it is confirmed that the door is in an open state.

The method may further include invalidating the first diagnosis result in the instance that the first diagnosis result is determined to be invalid.

The invalidating the first diagnosis result may include correcting the battery state value using the information on door status; and re-diagnosing whether the battery is abnormal based on the corrected battery state value.

The re-diagnosing whether the battery is abnormal may include generating a second diagnosis result in the instance that it is determined that an abnormality has occurred in the battery as a result of re-diagnosis; and outputting the second diagnosis result as a final diagnosis result.

The correcting the battery state value may include determining a duration for which the door is open; and correcting a battery state value associated with internal temperature of the container based on the duration for which the door is open.

The correcting the battery state value may include determining whether correction of the battery state value is possible based on an amount of change in the battery state value.

The determining whether the correction of the battery state value is possible may include determining that the correction of the battery state value is impossible in the instance that the amount of change in the battery state value exceeds a predetermined threshold.

According to another embodiment of the present disclosure, a battery test system, configured to test a battery by charging and discharging the battery, may include a container which accommodates the battery and includes an openable door; and a battery diagnosis apparatus configured to diagnose whether a battery is abnormal based on at least one battery state value during a process of charging and discharging the battery. Here, the battery diagnosis apparatus may generate a first diagnosis result in the instance that an abnormality occurs in the battery, verify validity of the first diagnosis result based on whether a door provided on a container accommodating the battery is opened or closed, and output the first diagnosis result as a final diagnosis result in the instance that the first diagnosis result is determined to be valid.

The battery diagnosis apparatus may further be configured to check information on door status at the time the at least one battery state value is collected; determine the first diagnosis result as valid in the instance that it is confirmed that the door is in a closed state; and determine that the first diagnosis result is invalid in the instance that it is confirmed that the door is in an open state.

The battery diagnosis apparatus may further be configured to invalidate the first diagnosis result in the instance that the first diagnosis result is determined to be invalid.

The battery diagnosis apparatus may further be configured to correct the battery state value using the information on door status and to re-diagnose whether the battery is abnormal based on the corrected battery state value.

Here, the battery diagnosis apparatus may further be configured to generate a second diagnosis result in the instance that it is determined that an abnormality has occurred in the battery as a result of re-diagnosis and to output the second diagnosis result as a final diagnosis result.

The battery diagnosis apparatus may further be configured to determine a duration for which the door is open and to correct a battery state value associated with internal temperature of the container based on the duration for which the door is open.

The battery diagnosis apparatus may further be configured to determine whether correction of the battery state value is possible based on an amount of change in the battery state value.

Here, the battery diagnosis apparatus may further be configured to determine that the correction of the battery state value is impossible in the instance that the amount of change in the battery state value exceeds a predetermined threshold.

[Advantageous Effects]

According to embodiments of the present disclosure, the accuracy of battery abnormality diagnosis can be significantly improved through outputting a final diagnostic result by verifying the validity of a diagnostic result based on whether the container is opened or closed.

[Brief Description of the Drawings]

FIG. 1 shows voltage values being monitored during battery charging and discharging.
FIG. 2 shows capacity values being monitored during battery charging and discharging.
FIG. 3 is a block diagram showing a battery system according to embodiments of the present invention.
FIG. 4 shows a container according to embodiments of the present invention.
FIG. 5 is an operational flowchart of a battery diagnosis method according to an embodiment of the present invention.
FIG. 6 is an operational flowchart of a battery diagnosis method according to another embodiment of the present invention.
FIG. 7 is a block diagram of a battery diagnosis apparatus according to embodiments of the present invention.
10: battery
100: container
111, 112: door
120: door lock
200, 700: battery diagnosis apparatus
300: operator terminal

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

State of charge (SOC) refers to a current charged state of a battery, represented in percent points [%]. Meanwhile, state of health (SOH) may be an indicator of current state as to degree of battery aging, represented in percent points [%].

A battery cell is a minimum unit that serves to store power and a battery module refers to an assembly in which a plurality of battery cells is electrically connected.

A battery pack or battery rack refers to a system of a single structure which is assembled by electrically connecting module units, set by a battery manufacturer, and can be monitored and controlled by a battery management apparatus/system (BMS). A battery pack or battery rack may include several battery modules and a battery protection unit or any other protection device.

A battery bank refers to a group of large-scale battery rack systems configured by connecting a plurality of racks in parallel. A bank BMS for a battery bank may monitor and control rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

Hereinafter, exemplary embodiments of the present invention will be described in detail with reference to the accompanying drawings.

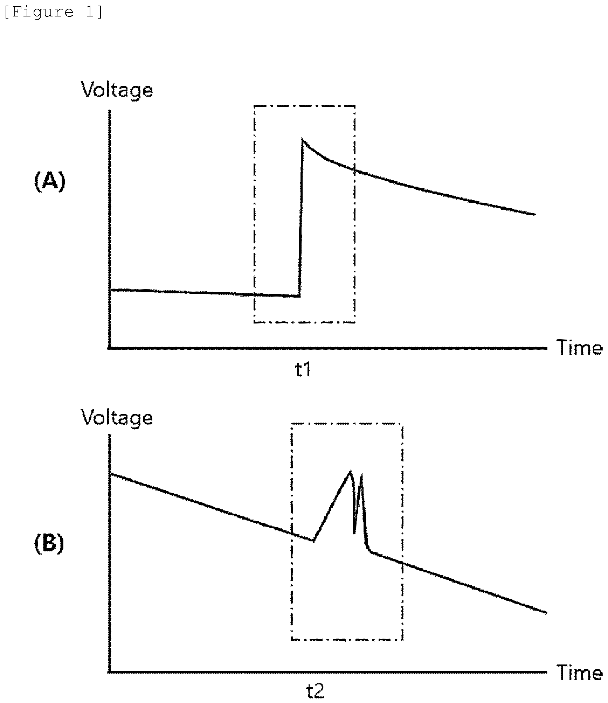

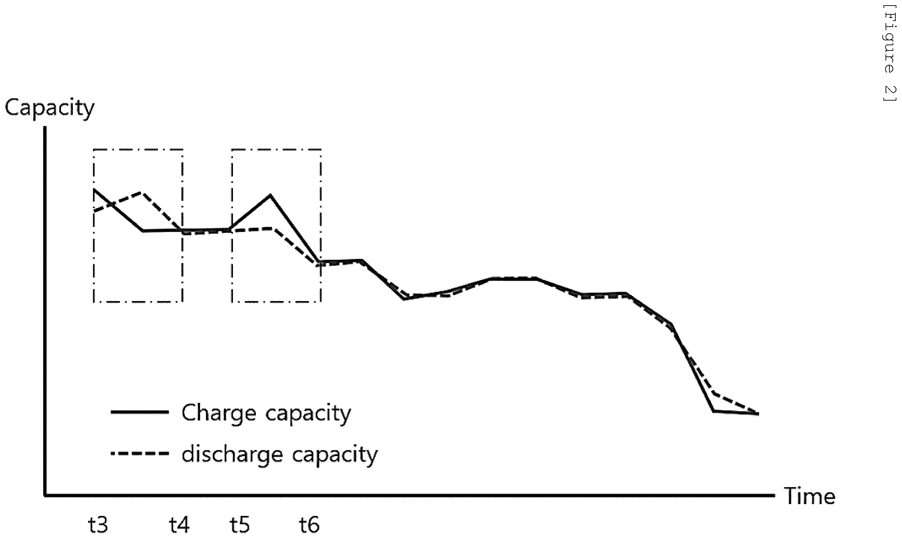

FIG. 1 shows voltage values being monitored during battery charging and discharging and FIG. 2 shows capacity values being monitored during battery charging and discharging.

A battery testing process may be performed in a manner in which a charge/discharge device repeatedly charges and discharges battery cells according to predetermined voltage and current conditions and measures electrical characteristics during the charge/discharge process.

Generally, in order to ensure safety of a battery test system when conducting a battery charge/discharge test, a state value of the battery is monitored to diagnose abnormalities such as whether ignition has occurred.

For example, a battery diagnosis apparatus provided in a battery system may be configured to monitor one or more state values such as battery voltage, battery surface temperature, and internal temperature of a container during a battery charging and discharging process. Here, the battery diagnosis apparatus may determine that an abnormality has occurred in the battery when the voltage and temperature exceed preset thresholds or the difference between charge capacity and discharge capacity calculated through the battery state values exceeds a preset reference value.

Meanwhile, a charging and discharging test is performed while the battery is housed inside a container with a certain internal space. If the door of the container is opened or closed during the test, the state value monitored for diagnosis may change.

Referring to (A) and (B) in FIG. 1, it can be understood that the voltage value of the battery changes due to physical shock generated at the time of door opening (t1 and t2) when the door of the container is opened.

In addition, referring to FIG. 2, when the door of the container is opened and closed, outside air flows in during the time period (t3 to t4, t5 to t6) for which the door is open and then closed and the internal temperature value of the container may fluctuate, thereby the calculated charging capacity and discharging capacity varying accordingly.

As described above, if the battery state value changes or is distorted due to the opening and closing of the container door, the battery diagnosis apparatus may misdiagnose that a problem has occurred even though there is no problem with the battery, and thus, the reliability of the diagnosis result will be lowered.

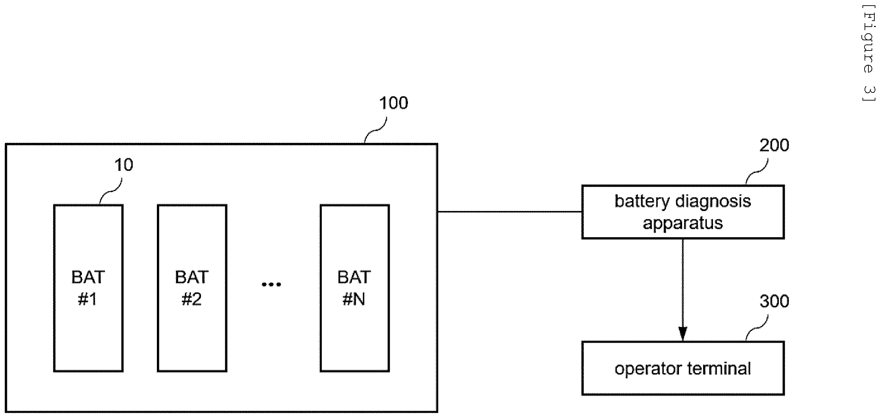

The present invention is intended to solve this problem. Hereinafter, various embodiments of the present invention will be described in detail with reference to FIGS. 3 to 7.

FIG. 3 is a block diagram showing a battery system according to embodiments of the present invention.

Referring to FIG. 3, the battery system may include a plurality of batteries 10 (BAT #1 to BAT #N), a container 100 accommodating the plurality of batteries therein, a battery diagnosis apparatus 200, and an operator terminal 300. In addition, the battery system may further include a charging and discharging device (not shown) that is electrically connected to the plurality of batteries 10 and performs charging and discharging of the batteries.

In embodiments, the battery system according to the present invention may correspond to a battery test system, but the scope of the present invention is not limited to this entity. For example, the battery diagnosis apparatus 200 according to the present invention, in addition to a battery test system for evaluating battery performance, may be applied to an energy storage system (ESS) and is configured to diagnose battery abnormalities during the battery charging and discharging process.

The battery 10 according to the present invention may refer to a battery cell or a battery assembly.

The battery diagnosis apparatus 200 may be configured to monitor at least one battery state value while the battery is being charged and discharged and diagnose whether there is an abnormality in the battery based on the battery state value. Here, the battery state value may include one or more of voltage, current, surface temperature of the battery, and internal temperature of the container.

When it is determined that an abnormality has occurred in the battery, the battery diagnosis apparatus 200 may generate a diagnostic result including one or more of a battery identifier, an abnormality type, and an abnormality occurrence time. Here, the battery diagnosis apparatus 200 may output the generated diagnosis result to the operator terminal 300.

The operator terminal 300 may correspond to a computing device managed by a manager or operator of the battery system. The operator terminal 300 may be configured to be connected to the battery diagnosis apparatus 200 through a wired or wireless network, receive a diagnosis result from the battery diagnosis apparatus 200, and output the diagnosis result through a display device.

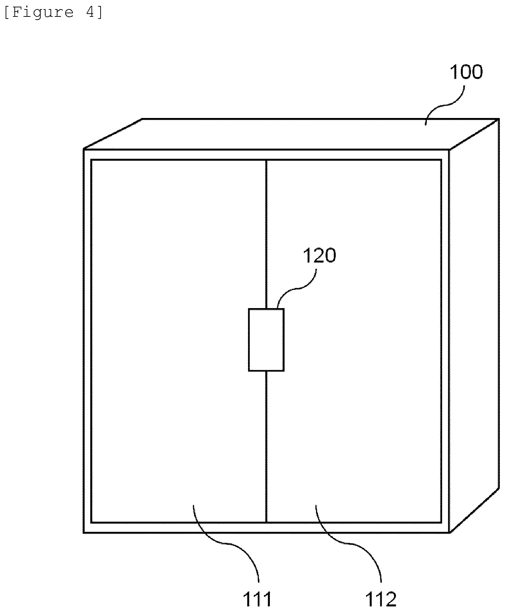

FIG. 4 shows a container according to embodiments of the present invention.

Referring to FIG. 4, the container 100 has a certain space inside to accommodate at least one battery and may be configured to include doors 111 and 112 that can be opened and closed.

The container 100 shown in FIG. 4 includes left and right doors 111 and 112, but the scope of the present invention is not limited to the structure shown in FIG. 4. In other words, it should be interpreted as a container according to the present invention as long as it is a container that includes a structure that can be opened and closed, regardless of the number, the shape, the coupling structure, or the name of the doors.

In an embodiment, the container 100 may further include a door lock 120 that controls whether the door is opened or closed. For example, the door lock 120 may correspond to a digital door lock that includes an unlock button or a numeric input pad that can be input by an operator.

The container 100 may be configured to include a detection sensor (not shown) capable of sensing open/closed state of the door. Here, the detection sensor may be included inside the door lock 120 or may be fixedly coupled to a specific area of the doors 111 and 112.

The battery diagnosis apparatus 200 may be connected with the detection sensor and receive state information of door from the detection sensor. Here, the battery diagnosis apparatus 200 may check whether the door is open or closed, open time, closing time, and a period of time being opened based on the received state information of door.

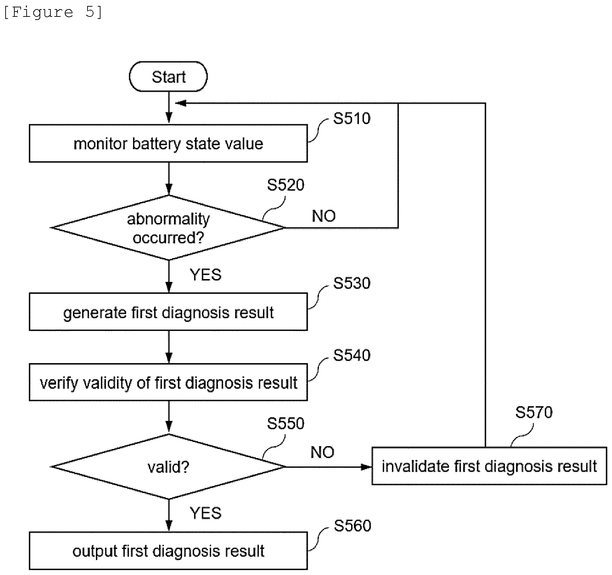

FIG. 5 is an operational flowchart of a battery diagnosis method according to an embodiment of the present invention.

When charging and discharging of the battery begins, the battery diagnosis apparatus 200 may monitor at least one battery state value during the charging and discharging process (S510). Here, the battery state value may include one or more of voltage, current, surface temperature of the battery, and internal temperature of the container.

Thereafter, the battery diagnosis apparatus 200 may diagnose whether there is an abnormality in the battery based on the battery state value (S520).

If it is determined that an abnormality has occurred in the battery as a result of the diagnosis (YES in S520), the battery diagnosis apparatus 200 may generate a first diagnosis result (S530). Here, the first diagnosis result may include one or more pieces of information among an identifier of the battery in which an abnormality occurred, a type of abnormality, and a time of abnormality occurrence.

Thereafter, the battery diagnosis apparatus 200 may verify the validity of the first diagnosis result based on whether a door provided in the container 100 is opened or closed (S54 0) .

More specifically, when a first diagnosis result is generated due to a battery abnormality, the battery diagnosis apparatus 200 may check information about door status at the time the battery state value, which is the basis of the first diagnosis result, is collected. Here, when it is assured that the door is in a closed state, the battery diagnosis apparatus 200 may determine that the first diagnosis result is valid. In addition, when it is assured that the door is open, the battery diagnosis apparatus 200 may determine that the first diagnosis result is invalid.

If the first diagnosis result is determined to be valid (YES in S550), the battery diagnosis apparatus 200 may output the first diagnosis result to the operator terminal 300 as the final diagnosis result (S560).

If the first diagnosis result is determined to be invalid (NO in S550), the battery diagnosis apparatus 200 may invalidate the first diagnosis result (S570). In other words, in the instance that the first diagnosis result is generated based on the battery state value measured while the door of the container is open, the first diagnosis result may be treated as invalid and may not be output to the operator terminal 300.

According to the embodiment of the present invention as described above, the validity of the diagnosis result is verified based on whether the door is open or closed and the final diagnosis result is output to the outside, thereby preventing misdiagnosis caused from data change or distortion due to the door opening.

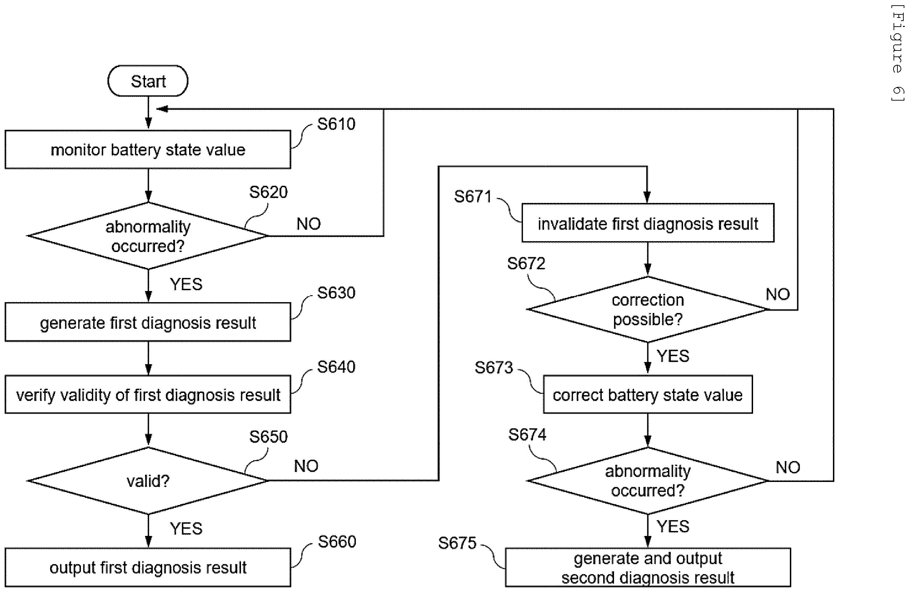

FIG. 6 is an operational flowchart of a battery diagnosis method according to another embodiment of the present invention.

When charging and discharging of the battery begins, the battery diagnosis apparatus 200 may monitor at least one battery state value during the charging and discharging process (S610).

Thereafter, the battery diagnosis apparatus 200 may diagnose whether there is an abnormality in the battery based on the battery state value (S620).

If it is determined that an abnormality has occurred in the battery as a result of the diagnosis (YES in S620), the battery diagnosis apparatus 200 may generate a first diagnosis result (S630). Here, the first diagnosis result may include one or more pieces of information among an identifier of the battery in which an abnormality occurred, a type of abnormality, and a time of abnormality occurrence.

Thereafter, the battery diagnosis apparatus 200 may verify the validity of the first diagnosis result based on whether a door provided in the container 100 is opened or closed (S640).

If the first diagnosis result is determined to be valid (YES in S650), the battery diagnosis apparatus 200 may output the first diagnosis result to the operator terminal 300 as the final diagnosis result (S660).

If the first diagnosis result is determined to be invalid (NO in S650), the battery diagnosis apparatus 200 may invalidate the first diagnosis result (S671).

After invalidating the first diagnosis result, the battery diagnosis apparatus 200 may correct the battery state value and re-diagnose whether the battery is abnormal based on the corrected battery state value.

In an embodiment, the battery diagnosis apparatus 200 may determine whether correction of the battery state value is possible based on an amount of change in the battery state value (S672). Here, the battery diagnosis apparatus 200 may determine that correction is not possible if the amount of change in the battery state value exceeds a preset threshold value and may determine that correction is possible if the amount of change in the battery state value is equal to or less than the threshold value.

For example, a physical shock may be applied to the battery when a container door is opened, causing the voltage value of the battery to fluctuate. Here, if the amount of change in the voltage value or the slope in the voltage curve exceeds a preset threshold, it may be determined that re-diagnosis based on correction is not possible.

If it is determined that correction of the battery state value is impossible (NO in S672), the final diagnosis result may not be transmitted to the operator terminal 300 due to invalidation of the first diagnosis result and the battery diagnosis apparatus 200 may perform a battery monitoring process by returning to S610.

If it is determined that correction of the battery state value is possible (YES in S672), the battery diagnosis apparatus 200 may correct the battery state value using the information about door status (S673). Here, the battery diagnosis apparatus 200 may check the duration for which the container door is open and correct a battery state value, which is associated with internal temperature of the container, based on the duration for which the container door is open.

In an embodiment, the battery diagnosis apparatus 200 may correct a battery capacity value based on the relationship (Equation 1) between the duration for which the container door is open and the capacity change per unit time.

[Equation 1]

$$d\_C = k1*\ln(t) + k2$$

(Here, d_C is a capacity correction value, t is a temperature inside the container, and k1 and k2 are constants which are calculated experimentally)

In more specific, the battery capacity may be calculated based on the internal temperature of the container. When the container door is opened, outside air flows in and the internal temperature value of the container changes, resulting in a capacity value different from the actual capacity value. Here, the battery diagnosis apparatus 200 may correct the battery capacity value by calculating a capacity correction value based on the duration for which the door is open (maintaining time of open) and Equation 1 above and adding the calculated capacity correction value to the capacity value before correction.

For example, when k1 is defined as 0.0047 and k2 as 0.0148, the temperature before opening the door is 10 degrees, the temperature just before closing after opening the door is 15 degrees, and the duration for which the container door is open is 60 seconds, the capacity correction value may be calculated as follows.

d_C = {(0.0047*ln(10) + 0.0148) - (0.0047*ln(15) + 0.0148)} * 60

Thereafter, the battery diagnosis apparatus 200 may re-diagnose whether the battery is abnormal based on the battery state value which is corrected according to S673 (S674).

When it is determined that an abnormality has occurred in the battery as a result of the re-diagnosis, (YES in S674), the battery diagnosis apparatus 200 may generate a second diagnosis result and output the second diagnosis result to the operator terminal 300 as the final diagnosis result (S675). Here, the second diagnosis result may include one or more information among an identifier of the battery in which an abnormality occurred, a type of abnormality, and a time of abnormality occurrence.

When it is determined that no problem has occurred in the battery as a result of the re-diagnosis (NO in S674), the first diagnosis result is invalidated and the final diagnosis result is not transmitted to the operator terminal 300 according to the re-diagnosis result (no abnormality). Furthermore, the battery diagnosis apparatus 200 may return to S610 and perform a battery monitoring process.

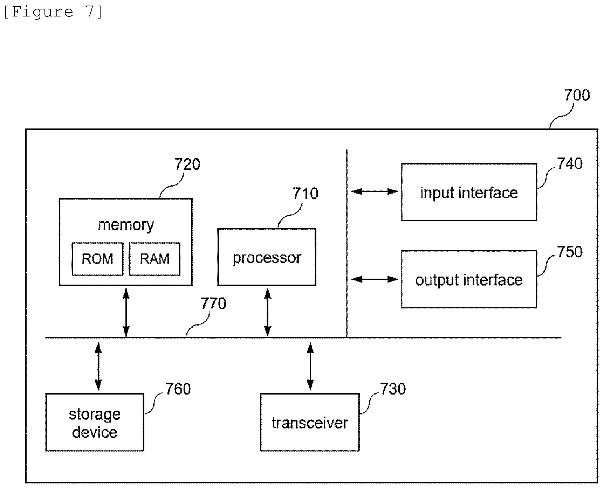

FIG. 7 is a block diagram of a battery diagnosis apparatus according to embodiments of the present invention.

The battery diagnosis apparatus 700 according to embodiments of the present invention may be configured to be included in a battery system or a battery test system. The battery diagnosis apparatus may include at least one processor 710, a memory 720 that stores at least one instruction executed through the at least one processor, and a transceiver 730 that is connected to a network and performs communication.

The at least one instruction may include an instruction to diagnose whether a battery is abnormal based on at least one battery state value during a process of charging and discharging the battery; an instruction to generate a first diagnosis result when an abnormality occurs in the battery; an instruction to verify validity of the first diagnosis result based on whether a door provided on a container accommodating the battery is opened or closed; and an instruction to output the first diagnosis result as a final diagnosis result in the instance that the first diagnosis result is determined to be valid.

The instruction to verify validity of the first diagnosis result may include an instruction to check door status information at the time the at least one battery state value is collected; an instruction to determine the first diagnosis result as valid when it is confirmed that the door is in a closed state; and an instruction to determine that the first diagnosis result is invalid when it is confirmed that the door is in an open state.

The at least one instruction may further include an instruction to invalidate the first diagnosis result in the instance that the first diagnosis result is determined to be invalid.

The instruction to invalidate the first diagnosis result may include an instruction to correct the battery state value using the information on door status; and an instruction to re-diagnose whether the battery is abnormal based on the corrected battery state value.

Here, the instruction to re-diagnose whether the battery is abnormal may include an instruction to generate a second diagnosis result in the instance that it is determined that an abnormality has occurred in the battery as a result of re-diagnosis; and an instruction to output the second diagnosis result as a final diagnosis result.

The instruction to correct the battery state value may include an instruction to determine a duration for which the door is open; and an instruction to correct a battery state value associated with internal temperature of the container based on the duration for which the door is open.

The instruction to correct the battery state value may include an instruction to determine whether correction of the battery state value is possible based on an amount of change in the battery state value.

Here, the instruction to determine whether the correction of the battery state value is possible may include an instruction to determine that the correction of the battery state value is impossible in the instance that the amount of change in the battery state value exceeds a predetermined threshold.

The battery diagnosis apparatus 700 may further include an input interface device 740, an output interface device 750, a storage device 760, etc. Respective components included in the battery diagnosis apparatus 700 may be connected by a bus 770 and can communicate with each other.

Here, the processor 710 may refer to a central processing unit (CPU), a graphics processing unit (GPU), or a dedicated processor on which methods according to embodiments of the present invention are performed. Additionally, the memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. A battery diagnosis apparatus located within a battery system, the apparatus comprising:

   at least one processor; and
   a memory configured to store at least one instruction executed by the at least one processor,
   wherein the at least one instruction includes:

   an instruction to diagnose whether a battery is abnormal based on at least one battery state value during a process of charging and discharging the battery;
   an instruction to generate a first diagnosis result in the instance that an abnormality occurs in the battery;
   an instruction to verify validity of the first diagnosis result based on whether a door provided on a container accommodating the battery is opened or closed; and
   an instruction to output the first diagnosis result as a final diagnosis result in the instance that the first diagnosis result is determined to be valid.

2. The battery diagnosis apparatus of claim 1, wherein the instruction to verify validity of the first diagnosis result includes:

   an instruction to check information on door status at the time the at least one battery state value is collected;
   an instruction to determine the first diagnosis result as valid in the instance that it is confirmed that the door is in a closed state; and
   an instruction to determine that the first diagnosis result is invalid in the instance that it is confirmed that the door is in an open state.

3. The battery diagnosis apparatus of claim 1, wherein the at least one instruction further includes an instruction to invalidate the first diagnosis result in the instance that the first diagnosis result is determined to be invalid.

4. The battery diagnosis apparatus of claim 3, wherein the instruction to invalidate the first diagnosis result includes:

   an instruction to correct the battery state value using the information on door status; and
   an instruction to re-diagnose whether the battery is abnormal based on the corrected battery state value.

5. The battery diagnosis apparatus of claim 4, wherein the instruction to re-diagnose whether the battery is abnormal includes:

   an instruction to generate a second diagnosis result in the instance that it is determined that an abnormality has occurred in the battery as a result of re-diagnosis; and
   an instruction to output the second diagnosis result as a final diagnosis result.

6. The battery diagnosis apparatus of claim 4, wherein the instruction to correct the battery state value includes:

   an instruction to determine a duration for which the door is open; and
   an instruction to correct a battery state value associated with internal temperature of the container based on the duration for which the door is open.

7. The battery diagnosis apparatus of claim 4, wherein the instruction to correct the battery state value includes an instruction to determine whether correction of the battery state value is possible based on an amount of change in the battery state value.

8. The battery diagnosis apparatus of claim 7, wherein the instruction to determine whether the correction of the battery state value is possible includes an instruction to determine that the correction of the battery state value is impossible in the instance that the amount of change in the battery state value exceeds a predetermined threshold.

9. A battery diagnosing method performed by a battery diagnosis apparatus located within a battery system, the battery diagnosing method comprising:

diagnosing whether a battery is abnormal based on at least one battery state value during a process of charging and discharging the battery;
generating a first diagnosis result in the instance that an abnormality occurs in the battery;
verifying validity of the first diagnosis result based on whether a door provided on a container accommodating the battery is opened or closed; and
outputting the first diagnosis result as a final diagnosis result in the instance that the first diagnosis result is determined to be valid.

10. The battery diagnosing method of claim 9, wherein the verifying validity of the first diagnosis result includes:

checking information on door status at the time the at least one battery state value is collected;
determining the first diagnosis result as valid in the instance that it is confirmed that the door is in a closed state; and
determining that the first diagnosis result is invalid in the instance that it is confirmed that the door is in an open state.

11. The battery diagnosing method of claim 9, further comprising invalidating the first diagnosis result in the instance that the first diagnosis result is determined to be invalid.

12. The battery diagnosing method of claim 11, wherein the invalidating the first diagnosis result includes:

correcting the battery state value using the information on door status; and
re-diagnosing whether the battery is abnormal based on the corrected battery state value.

13. The battery diagnosing method of claim 12, wherein the re-diagnosing whether the battery is abnormal includes:

generating a second diagnosis result in the instance that it is determined that an abnormality has occurred in the battery as a result of re-diagnosis; and
outputting the second diagnosis result as a final diagnosis result.

14. The battery diagnosing method of claim 12, wherein the correcting the battery state value includes:

determining a duration for which the door is open; and
correcting a battery state value associated with internal temperature of the container based on the duration for which the door is open.

15. The battery diagnosing method of claim 12, wherein the correcting the battery state value includes determining whether correction of the battery state value is possible based on an amount of change in the battery state value.

16. The battery diagnosing method of claim 15, wherein the determining whether the correction of the battery state value is possible includes determining that the correction of the battery state value is impossible in the instance that the amount of change in the battery state value exceeds a predetermined threshold.

17. A battery test system configured to test a battery by charging and discharging the battery, the battery test system comprising:

a container which accommodates the battery and includes an openable door; and
a battery diagnosis apparatus configured to diagnose whether a battery is abnormal based on at least one battery state value during a process of charging and discharging the battery,
wherein the battery diagnosis apparatus generates a first diagnosis result in the instance that an abnormality occurs in the battery, verifies validity of the first diagnosis result based on whether the door provided on the container accommodating the battery is opened or closed, and outputs the first diagnosis result as a final diagnosis result in the instance that the first diagnosis result is determined to be valid.

18. The battery test system of claim 17, wherein the battery diagnosis apparatus is further configured to:

check information on door status at the time the at least one battery state value is collected;

determine the first diagnosis result as valid in the instance that it is confirmed that the door is in a closed state; and

determine that the first diagnosis result is invalid in the instance that it is confirmed that the door is in an open state.

19. The battery test system of claim 17, wherein the battery diagnosis apparatus is further configured to invalidate the first diagnosis result in the instance that the first diagnosis result is determined to be invalid.

20. The battery test system of claim 19, wherein the battery diagnosis apparatus is further configured to correct the battery state value using the information on door status and to re-diagnose whether the battery is abnormal based on the corrected battery state value.

21. The battery test system of claim 20, wherein the battery diagnosis apparatus is further configured to generate a second diagnosis result in the instance that it is determined that an abnormality has occurred in the battery as a result of re-diagnosis and to output the second diagnosis result as a final diagnosis result.

22. The battery test system of claim 20, wherein the battery diagnosis apparatus is further configured to determine a duration for which the door is open and to correct a battery state value associated with internal temperature of the container based on the duration for which the door is open.

23. The battery test system of claim 20, wherein the battery diagnosis apparatus is further configured to determine whether correction of the battery state value is possible based on an amount of change in the battery state value.

24. The battery test system of claim 23, wherein the battery diagnosis apparatus is further configured to determine that the correction of the battery state value is impossible in the instance that the amount of change in the battery state value exceeds a predetermined threshold.

[Figure 1]

[Figure 2]

[Figure 3]

[Figure 4]

[Figure 5]

[Figure 6]

[Figure 7]

## INTERNATIONAL SEARCH REPORT

| International application No. |
|---|
| **PCT/KR2023/019589** |

**A.    CLASSIFICATION OF SUBJECT MATTER**

**G01R 31/367**(2019.01)i; **G01R 31/392**(2019.01)i; **G01R 31/374**(2019.01)i; **G07C 9/00**(2006.01)i

According to International Patent Classification (IPC) or to both national classification and IPC

**B.    FIELDS SEARCHED**

Minimum documentation searched (classification system followed by classification symbols)

G01R 31/367(2019.01); G01R 31/36(2006.01); H01M 10/48(2006.01); H01M 2/02(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 컨테이너(container), 도어(door), 유효성(validity)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2016-0034018 A (LG CHEM, LTD.) 29 March 2016 (2016-03-29)<br>See paragraphs [0051]-[0061] and figures 1-3. | 1-24 |
| A | KR 10-0669475 B1 (SAMSUNG SDI CO., LTD.) 16 January 2007 (2007-01-16)<br>See paragraphs [0017]-[0086] and figures 1-4. | 1-24 |
| A | JP 2014-163921 A (FUJITSU TELECOM NETWORKS LTD.) 08 September 2014 (2014-09-08)<br>See paragraphs [0016]-[0051] and figures 1-5. | 1-24 |
| A | KR 10-2018-0122116 A (LG CHEM, LTD.) 12 November 2018 (2018-11-12)<br>See paragraphs [0032]-[0064] and figures 1-2. | 1-24 |
| A | KR 10-2021-0081095 A (SAMSUNG SDI CO., LTD.) 01 July 2021 (2021-07-01)<br>See paragraphs [0035]-[0080] and figures 1-3. | 1-24 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 March 2024** | **14 March 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/019589**

| Patent document cited in search report | | | Publication date (day/month/year) | Patent family member(s) | | | Publication date (day/month/year) |
|---|---|---|---|---|---|---|---|
| KR | 10-2016-0034018 | A | 29 March 2016 | KR | 10-1751011 | B1 | 26 June 2017 |
| KR | 10-0669475 | B1 | 16 January 2007 | CN | 100541969 | C | 16 September 2009 |
| | | | | CN | 1988314 | A | 27 June 2007 |
| | | | | EP | 1801604 | A2 | 27 June 2007 |
| | | | | EP | 1801604 | A3 | 11 July 2007 |
| | | | | EP | 1801604 | B1 | 29 October 2008 |
| | | | | US | 2007-0139015 | A1 | 21 June 2007 |
| | | | | US | 7728555 | B2 | 01 June 2010 |
| JP | 2014-163921 | A | 08 September 2014 | | None | | |
| KR | 10-2018-0122116 | A | 12 November 2018 | KR | 10-2227308 | B1 | 15 March 2021 |
| KR | 10-2021-0081095 | A | 01 July 2021 | CN | 113093022 | A | 09 July 2021 |
| | | | | EP | 3843195 | A1 | 30 June 2021 |
| | | | | EP | 3843195 | B1 | 03 August 2022 |
| | | | | HU | E060481 | T2 | 28 March 2023 |
| | | | | PL | 3843195 | T3 | 26 September 2022 |
| | | | | US | 11802918 | B2 | 31 October 2023 |
| | | | | US | 2021-0190881 | A1 | 24 June 2021 |

Form PCT/ISA/210 (patent family annex) (July 2022)

**EP 4 513 211 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230015396